# EUROPEAN PATENT SPECIFICATION

(11) **EP 2 453 040 B1**
(45) Date of publication and mention of the grant of the patent: **30.04.2014**
(21) Application number: 10797113.7
(22) Date of filing: 06.07.2010
(51) Int. Cl.: C23C 18/20, H05K 3/00, H05K 3/10, H05K 3/18

(54) **METHOD FOR PRODUCING FORMED CIRCUIT COMPONENT**
VERFAHREN ZUR HERSTELLUNG EINER GEFORMTEN SCHALTUNGSKOMPONENTE
PROCÉDÉ DE FABRICATION D UN COMPOSANT DE CIRCUIT FAÇONNÉ

(30) Priority: 10.07.2009 JP 2009164028
(43) Date of publication of application: 16.05.2012
(73) Proprietor: Sankyo Kasei Co., Ltd., Tokyo146-0085 (JP)
(72) Inventor: YUMOTO, Tetsuo, Tokyo 146-0085 (JP)
(74) Representative: Schwabe - Sandmair - Marx
(86) International application number: PCT/JP2010/061434
(87) International publication number: WO 2011/004802

(56) References cited:
- WO-A1-2008/056603
- JP-A- 7 212 008
- JP-A- 10 317 153
- JP-A- 63 186 877
- JP-A- 2001 177 219
- JP-A- 2007 180 089
- JP-B2- 2 948 366
- US-A1- 2003 011 049

## Description

### Technical Field

The present invention relates to a method for producing a formed circuit component, and in particular to a method for producing a formed circuit component, in which the surface of a substrate is irradiated with a laser ray to be roughened, and a electroless plating is formed onto the roughened surface.

### Background Art

In a method for producing a formed circuit component, in which the surface of a substrate made of a synthetic resin is selectively electroless-plated to form an electroconductive circuit, it has been hitherto necessary to roughen the substrate surface in advance by etching the surface in order to improve the adhesiveness between the surface and the electroless plating. A typical method of the etching is chemical etching using hexavalent chromium sulfate (see Patent Literatures 1 and 2).

### Citation List

### Patent Literature

Patent Literature 1: Japanese Patent Application Laid-Open (JP-A) No. 10-335781 A
Patent Literature 2: JP-A No. 10-335782 A

### Summary of Invention

### Technical Problems

However, hexavalent chromium is poisonous to give a risk to work. Furthermore, in order to treat safely a waste liquid which is a used etching liquid, it is necessary to reduce hexavalent chromium therein into trivalent chromium, and then treat the trivalent chromium to be neutralized and precipitated. This, a very troublesome processing is required. For this reason, hexavalent chromium sulfate is designated to a substance prohibited from being used in a product from an environmental viewpoint. In the roughening of the substrate surface by chemical etching, the entire surface is roughened; thus, when the surface made rough is used, as it is, as an exterior, it is necessary to decorate the surface by painting or some other.

Thus, an object of the invention is to provide a method for producing a formed circuit component, wherein the surface of a substrate is roughened without using any chemical etchant. Solution to Problem

In order to solve the above-mentioned problems, the inventors have verified that a laser ray is radiated onto the surface of a substrate composed of an insulating material to roughen the surface, thereby obtaining a sufficient adhesiveness between the surface and an electroless plating thereon, and found out that the environmental problem according to conventional chemical etching, and other problems can be solved. Furthermore, a laser ray is radiated selectively onto only a circuit forming region (a region of the substrate surface composed of an insulating material, on which region an electroless plating is to be deposited and formed a circuit in a subsequent step), thereby shortening the period for roughening the surface largely. Additionally, by avoiding roughening a non-circuit forming region (a region on which region the circuit is not formed), it has been possible to eliminate the decoration for the non-circuit forming region according to painting or some other.

Accordingly, a first aspect of a method for producing a formed circuit component according to the invention includes: a first step of forming a substrate composed of an insulating material; a second step of radiating a first laser ray thereon, thereby roughening either the substrate surface, or only a circuit forming region of the substrate surface; a third step of immersing the substrate in a catalytic liquid, thereby supplying a catalyst for electroless-plating onto the substrate surface; a fourth step of drying the substrate surface, thereby fixing the catalyst onto the substrate surface; a fifth step of radiating a second laser ray onto a non-circuit forming region of the substrate surface, thereby lowering or eliminating the function of the catalyst fixed onto the non-circuit forming region; and a sixth step of electroless-plating the circuit forming region of the substrate surface.

An important point of this method is that even when the first laser is radiated only onto the circuit forming region of the substrate surface and selectively roughen, it is necessary in the fifth step to lower or eliminate the function of the catalyst fixed onto the non-circuit forming region. In other words, when only the circuit forming region is made selectively rough, a strong adhesiveness can be certainly kept between the circuit forming region and an electroless plating thereon; however, an electroless plating is formed also on the non-circuit forming region which has not been roughened, although the adhesiveness of the plating to that region is low. As a result, it is difficult to form the circuit forming region precisely. Thus, even when only the circuit forming region is made selectively rough in the second step, it is necessary in the fifth step to lower or eliminate the function of the catalyst fixed onto the non-circuit forming region.

In the substrate surface to which the catalyst has been supplied,the scope onto which the second laser ray is radiated is changed to the boundary between the circuit forming region and non-circuit forming region, from the non-circuit forming region, so as to lower or eliminate the function of the catalyst fixed onto this boundary, no electroless plating is formed on this boundary by electroless-plating in one of the subsequent steps. Accordingly, the electroless plating formed onto both of the circuit forming region and the non-circuit forming region is electrically separated into plural pieces by the boundary. As a result, bypassing electric current into only the electroless plating on the circuit forming region, an electroplating can be deposited thereon. As the electroplating on the circuit forming region can easily be made thicker than any other electroless plating, then, only the electroless plating formed on non-circuit forming region can easily be removed by soft etching or some other.

Accordingly a second aspect of the method for producing a formed circuit component according to the invention includes: a first step of forming a substrate composed of an insulating material; a second step of radiating a first laser ray thereon, thereby roughening either the surface of the substrate, or only a circuit forming region; a third step of immersing the substrate in a catalytic liquid, thereby supplying a catalyst for electroless-plating onto the substrate surface; a fourth step of drying the substrate surface, thereby fixing the catalyst onto the substrate surface; a fifth step of radiating a second laser ray onto a boundary between the circuit forming region and a non-circuit forming region of the substrate surface, thereby lowering or eliminating the function of the catalyst fixed onto the boundary; a sixth step of electroless-plating both of the circuit forming region and the non-circuit forming region of the substrate surface; a seventh step of electroplating a surface of the electroless plating on the circuit forming region of the substrate surface; and an eighth step of eliminating the electroless plating on the non-circuit forming region of the substrate surface by etching.

In the second step, even when the first laser ray is radiated only to the circuit forming region, and is selectively roughened, it is necessary in the fifth step to lower or eliminate the function of the catalyst fixed onto the boundary between the circuit forming region and the non-circuit forming region for the following reason: as described above, unless the function of the catalyst fixed onto this boundary is lowered or eliminated, an electroless plating is formed on this boundary although the adhesiveness thereof is low.

Moreover, a circuit made of an electroless plating can be formed by roughening a substrate surface containing an insulating material, supplying a catalyst to the substrate surface, electroless-plating the whole of the substrate surface, and then removing the electroless plating on a non-circuit forming region of the surface by a selective radiation of a laser ray. Accordingly, a third aspect of the method for producing a formed circuit component according to the invention includes: a first step of forming a substrate composed of an insulating material; a second step of radiating a first laser ray thereon, thereby roughening either a substrate surface, or only a circuit forming region; a third step of immersing the substrate in a catalytic liquid, thereby supplying a catalyst for electroless-plating onto the substrate surface; a fourth step of electroless-plating the substrate surface; and a fifth step of radiating a second laser ray onto a non-circuit forming region of the substrate surface, thereby eliminating the electroless plating on the non-circuit forming region.

In the second step, even when the first laser ray is radiated only the circuit forming region of the substrate surface and selectively roughen the circuit forming region, it is necessary in the fifth step to remove the electroless plating formed on the non-circuit forming region by radiating the second laser ray for the following reason: as described above, also on the non-circuit forming region not roughened, the electroless plating is formed on the non-circuit forming region although the adhesiveness of the electroless plating to that region is low; thus, it is necessary to remove the electroless plating on the non-circuit forming region.

An electroless plating formed on a circuit forming region and a non-circuit forming region is electrically separated each other by roughening whole surface of the substrate composed of an insulating material, supplying a catalyst thereto, electroless-plating the substrate surface, and then removing the electroless plating on a boundary between the circuit forming region and the non-circuit forming region with a selective radiation of a second laser ray. Therefore an electroplating can be deposited on a surface of the electroless plating formed on the circuit forming region by passing an electric current into only the electroless plating formed on the circuit forming region. As the electroplating on the circuit forming region can easily be made thicker than any other electroless plating, therefore, as described above, the electroless plating formed on the non-circuit forming region can easily be removed by soft etching or some other.

Accordingly, a fourth aspect of the method for producing a formed circuit component according to the invention, includes: a first step of forming a substrate composed of an insulating material; a second step of radiating a first laser ray thereon, thereby roughening either the substrate surface, or only a circuit forming region of the substrate surface; a third step of immersing the substrate in a catalytic liquid, thereby supplying a catalyst for electroless-plating onto the substrate surface; a fourth step of electroless-plating the substrate surface; a fifth step of radiating a second laser ray onto a boundary between the circuit forming region and a non-circuit forming region of the substrate surface, thereby eliminating the electroless plating applied to the boundary; a sixth step of electroplating a surface of the elctroless-plating on the circuit forming region of the substrate surface; and a seventh step of eliminating the electroless plating on the non-circuit forming region of the substrate surface by etching.

In the second step, even when the first laser ray is radiated only to the circuit forming region of the substrate surface and selectively roughened, it is necessary in the fifth step to remove the electroless plating formed on the boundary between the circuit forming region and the non-circuit forming region by radiating the second laser ray for the following reason: as described above, the electroless plating is formed on the region not made rough although the adhesiveness to that region is low, so that the electroless plating is formed on the boundary also; thus, it is necessary to remove the electroless plating formed on this boundary to keep electrical insulation certainly between the circuit forming region and the non-circuit forming region.

Incidentally, when the first laser ray is radiated in the second step to roughen only the circuit forming region of the substrate surface, it is desired in the fifth step to radiate the second laser ray onto an area extending from the circumferential edge of the circuit forming region toward the inside of the circuit forming region, in such a manner that the first-laser-ray-radiated area and the cond-layer-ray-radiated area overlap with each other by only a predetermined width.

Specifically, in the case of roughening only the circuit forming region in the second step, and next radiating the second laser ray onto the non-circuit forming region, or onto the boundary between the circuit forming region and the non-circuit forming region in the fifth step, it is necessary to radiate the second laser ray precisely along the circumferential edge of the circuit forming region that was roughened. In other words, when the second laser ray is radiated inaccurately onto the outside area removed from the circumferential edge of the circuit forming region, the function of the catalyst on the outside area is not lowered or eliminated, and then the electroless plating is formed onto the outside area. It is therefore difficult to form a precise electroconductive circuit. However, it is very difficult to radiate the second laser ray precisely along the circumferential edge of the circuit forming region that was roughened.

Thus, when the second laser ray is radiated after the radiation of the first laser ray, it is advisable to radiating the second-laser-ray to overlap the circuit forming region that was roughened by the radiation of the first laser ray, by a predetermined width from the circumferential edge of the circuit forming region. In this case, it is possible to prevent, with ease and certainty, the generation of the region that is not roughened by the radiation of the first laser ray, and not radiated by the second laser ray. Accordingly, when a region obtained by excluding the area of overlap 1e from the circumferential of the circuit forming region 1a made rough, is beforehand set as a real circuit forming region, the electroconductive circuit can be formed with precision and ease on the real circuit forming region.

In the wording "forming a substrate composed of an insulating material", the word "insulating material" means, for example, synthetic resin, ceramic material, and glass. The synthetic resin is preferably thermoplastic resin. The resin may be, however, thermosetting resin. Examples of the resin include aromatic liquid crystal polymer, polyetheretherketone, polysulfone, polyetherpolysulfone, polyarylsulfone, polyetherimide, polyester, acrylonitrile/butadiene/styrene copolymer resin, polyamide, modified polyphenylene oxide resin, norbornene resin, phenolic resin, and epoxy resin.

The word "substrate" means a member having a surface on which an electroconductive circuit can be formed. The form thereof is arbitrary. The substrate may be, for example, in the form of a film, a flat plate, a polygonal block, a body having a curved surf ace, or a rod, and may be composed of plural components. As the substrate, a substrate that is made of an insulating material, and the substrate that is an electroconductive member covered with an insulating material For "the first laser ray" and "the second laser ray", the same laser-ray-radiating machine may be used. The laser rays are not limited in the kind as far as the rays make it possible to attain a trace-amount-removing operation, such as scribing or trimming. Examples thereof include YAG laser, second harmonic laser, CO₂ laser, Ar laser, and the like.

The wording "a substrate surface " means the entire surface of the substrate. The wording "roughen " means that a surface layer of the substrate is melted or sublimated by the first laser ray. More specifically, while a beam obtained by narrowing the first laser ray through a lens is radiated on the substrate surface in a pulse manner, the beam is scanned along the substrate surface, therebymelting or sublimating fine portions in the surface layer of the substrate to make fine irregularities. The wording "supplying a catalyst" means the following: the substrate is immersed in, for example, a tin-based or palladium-based mixed catalytic liquid, and it is then activated with an acid such as hydrochloric acid or sulfuric acid to precipitate palladium on the surface, or a relatively strong reducing agent, such as stannous chloride, is adsorbed on the surface, and the substrate is immersed in a catalytic solution containing a noble metal, such as gold, to precipitate gold on the surface. The wording "the function of the catalyst is lowered or eliminated" means that the second laser ray is radiated onto the substrate surface, thereby sublimating the catalyst adhering onto the surface partially or wholly so as to be removed.

As the "electroless-plating", any known electroless-plating process may be used. Examples of the metal for the electroless plating include copper, nickel, nickel alloys, and noble metals such as silver and gold. Metals of the same kind or different types may be used in the plating to form a bilayered or multilayered plating. As the "electroplating", any known electroplating process may be used. Examples of a metal for the electroplating plating include copper, nickel, silver, gold, or the alloy thereof. Metals of the same kind or different types may be used in the plating to form a bilayered or multilayered plating. In the case of "removing the electroless plating by etching", the means for the "etching" may be any means as far as the means makes it possible to dissolve the plating metal of the electroless plating. The means is, for example, to immerse the substrate on which the electroless plating is formed into an aqueous solution wherein ferric chloride is dissolved in sulfuric acid, or an aqueous solution of sodium persulfate.

### Advantageous Effects of Invention

By radiating the laser ray onto the surface of the substrate composed of the insulating material to roughen the surface, a sufficient adhesiveness can gain between the roughened surface and any electroless plating, and the environmental problem can be solved, which results from chemical etching in the prior art. Moreover, by radiating the laser ray selectively onto only the circuit forming region on which an electroless plating is to be deposited in one of the subsequent steps, the period for the roughening can be largely shortened, and further by avoiding to roughen the non-circuit forming region, the decoration thereof by painting or some other can be eliminated.

By supplying the catalyst after roughening the substrate surface, and then radiating the second laser ray onto the boundary between the circuit forming region and non-circuit forming region to lower or eliminate the function of the catalyst in this boundary region, the electroless plating formed on the circuit forming region can be electrically insulated from that formed on the non-circuit forming region. Accordingly, an electroplating can be deposited with precision and ease onto only the surface of the electroless plating formed on the circuit forming region.

By supplying the catalyst after roughening the substrate surface, forming the electroless plating on the entire surface of the substrate, and then removing the electroless plating on the non-circuit forming region by the radiation of the second laser ray except circuit forming region, an electroconductive circuit made of the electroless plating can be formed with precision and ease. Moreover, by forming the electroless plating on the whole of the substrate surface, and removing the electroless plating on the boundary region between the circuit forming region and the non-circuit forming region by the radiation of the second laser ray, the electroless plating formed on the circuit forming region can be electrically insulated from that on the non-circuit forming region. Accordingly, an electroplating can be deposited with precision and ease onto only the surface of the electroless plating formed on the circuit forming region.

Further, in the case when only the circuit forming region of the substrate surface is selectively roughened by the radiation of the first laser ray, and the second laser ray is radiated onto the non-circuit forming region or the boundary between the circuit forming region and the non-circuit forming region, it is possible to prevent an electroless plating with low adhesiveness from being formed and left on the region that is not roughened. Furthermore, when only the circuit forming region is selectively roughened by the radiation of the first radiation, by radiating the second laser ray onto the area extending toward the inside from the circumferential edge of the circuit forming region, in such a manner that the second-layer-ray-radiated area overlaps with the first-laser-ray-radiated area each other by only a predetermined width, an electroconductive circuit can be formed with precision and ease.

### Brief Description of Drawings

FIG. 1 is a process chart illustrating a method for producing a formed circuit component.
FIG. 2 is another process chart illustrating a method for producing a formed circuit component.
FIG. 3 is still another process chart illustrating a method for producing a formed circuit component.
FIG. 4 is a further process chart illustrating a method for producing a formed circuit component.
FIG. 5 is an explanatory view for describing a reason why a second laser ray is radiated onto a circuit forming region in such a manner that a first-laser-ray-radiated area and a second-laser-ray-radiated area overlap with each other.

### Reference Signs List

- 1, 101 to 310: Substrates
- 1a, 101a to 301a: circuit forming regions
- 1b, 101b to 301b: non-circuit forming regions
- 101c, 310c: Boundaries
- 1e: Overlap
- 2, 102 to 302: First laser rays
- 3, 103 to 303: Catalysts
- 4, 104 to 304: Second laser rays
- 5, 105 to 305: Electroless platings
- 106, 306: Electroplatings

### Best Mode for Carrying Out the Invention

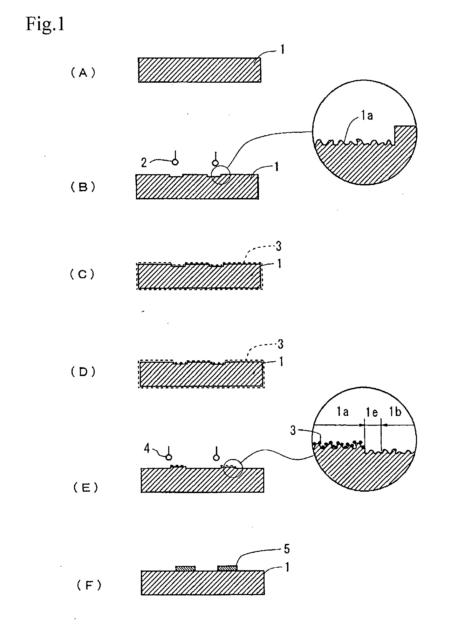

With reference to FIGS. 1 to 5, a description is made about the method according to the invention for producing a formed circuit component. As illustrated in FIG. 1, the formed-circuit-component-producing method according to the invention has first to sixth steps (FIG. A to FIG. F). In the first step (FIG. A), polyetherketone (for example, a product "Victrex #450" manufactured by Victrex Co.), which is a thermoplastic resin, is injected-molded to be formed or shaped into a substrate 1. Next, in the second step (FIG. B), a first-laser-ray 2 is radiated thereto to roughen selectively only a circuit forming region 1a inside the surface of the substrate 1. By the radiation of the laser ray 2, the entire surface of the substrate 1 may be roughened. For example, the first laser ray 2 is a second harmonic wave, and is scanned three times at a power of 6 W, a scanning speed of 1000 mm/second, and a Q switch frequency of 30 kHz, The roughened surface is dented into a depth of about 12 µm from the surface of the substrate 1.

Next, in the third step (FIG. C), the substrate 1 is immersed in a catalytic liquid to supply a catalyst 3 for electroless-plating onto the entire surface of this substrate. For the supply of the catalyst 3, a known means may be used. For example, the substrate 1 is immersed in a tin-based or palladium-based mixed catalytic liquid, and it is then activated with an acid such as hydrochloric acid or sulfuric acid to precipitate palladium on the surface. Alternatively, it is allowable to adsorb a relatively strong reducing agent, such as stannous chloride, on the surface, and immerse the substrate 1 in a catalytic solution containing a noble metal, such as gold, to precipitate gold on the surface. Next, in the fourth step (FIG. D), as a pre-step for second-laser-ray-4-radiation of dry working in the next fifth step, the surface of the substrate 1, to which the catalyst 3 is supplied, is dried to fix this catalyst onto the surface of this substrate.

In the fifth step (FIG. E), a second laser ray 4 is radiated onto a non-circuit forming region 1b of the substrate 1 surface to eliminate the catalyst 3 fixed onto this region. As illustrated in a partially enlarged view of FIG. E, the second laser ray 4 is radiated onto an area (overlap 1e) extending from the circumferential edge of the circuit forming region 1a, toward the inside of the circuit forming region in such a manner that the first-laser-ray-radiated area and the second-laser-ray-radiated area overlap with each other by only a predetermined width (1e). The reason therefor and others will be described in detail later. For example, the second-laser-ray 4 is a second harmonic wave, and is scanned three times at a power of 6 W, a scanning speed of 500 mm/second, and a Q switch frequency of 30 kHz, The surface irradiated with the second laser ray 4 is dented into a depth of about 42 µm from the surface of the substrate 1.

In the final step, the sixth step (FIG. F), the circuit forming region 1a, which keeps the function of the catalyst 3 is electroless-plated to form an electroless plating 5. The electroless plating 5 is not precipitated onto the non-circuit forming region 1b, since the catalyst 3 is eliminated therefrom by the radiation of the second laser ray 4 in the pre-step. For the electroless plating 5, a known means may be used. In the case of, for example, copper-electroless-plating, the following plating liquid is used while the temperature thereof is kept at 20°C: a plating liquid of a mixture of 5 to 10 g/L of copper sulfate as a metal salt, 8 to 12 mL/L of a 37 volume% solution of formalin as a reducing agent, 20 to 25 g/L of a Rochelle salt as a complexing material, and 5 to 12 g/L of sodium hydroxide as an alkaline agent. Instead of the copper-electroless-plating, nickel-electroless-platingmaybe conducted. Onto the electroless plating 5, electroless-plating or electroplating with a different metal can easily be attained to deposit the metal thereon.

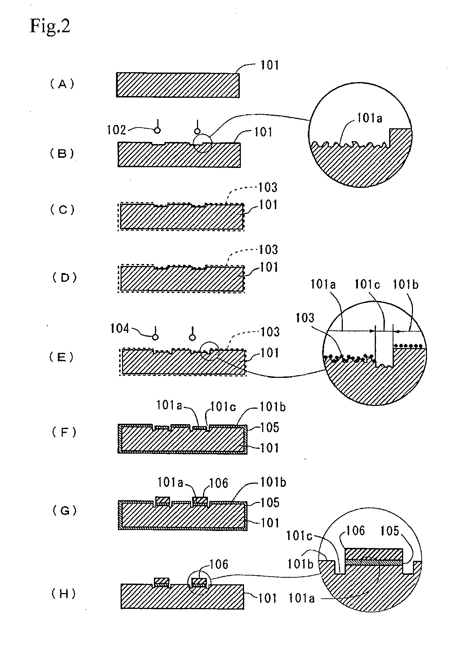

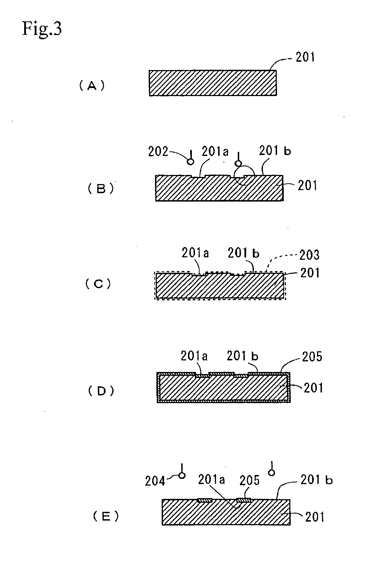

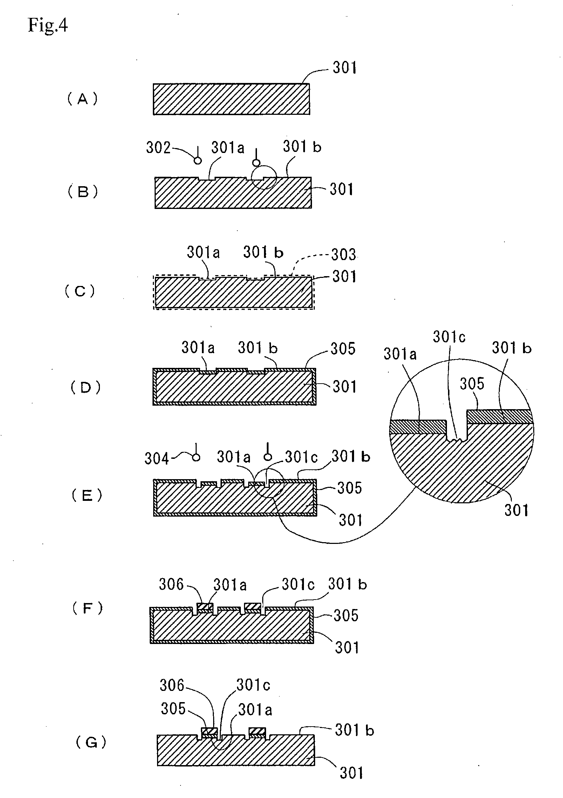

FIG. 2 illustrates another method according to the invention for producing a formed circuit component. This production method has first to eighth steps (FIGS. A to H). The first to fourth steps (FIGS. A to D) are equivalent to the first to fourth steps illustrated in FIG. 1. Components or portions equivalent to those illustrated in FIG. 1 have reference numbers obtained by adding 100 uniformly to the component reference numbers illustrated in FIG. 1, respectively, for the sake of convenience for reference, and others (in the same manner as in FIG. 3 as well as in FIG. 4, 200 as well as 300 is uniformly added to the component reference numbers illustrated in FIG. 1, respectively).

In the fifth step (FIG. E), a second laser ray 104 is radiated onto a boundary 101c between the circuit forming region 101a and the non-circuit forming region 101b of the substrate 101 surface, to eliminate the catalyst 103 fixed on this boundary. The specification and the effect of the second laser ray 104 are equivalent to those of the second laser ray 4 described with reference to FIG. 1. The second laser ray 104 is radiated to make an invasion into the circuit forming region 101a, in such a manner that the first-laser-ray-radiated area and the second-laser-ray-radiated area overlap with each other.

Next, in the sixth step (FIG. F), the circuit forming region 101a and the non-circuit forming region 101b of the substrate 101 surface, are electroless-plated to form an electroless plating 105. The electroless plating 105 is not formed on the boundary 101c between the circuit forming region 101a and the non-circuit forming region 101b, since the catalyst 103 is eliminated thereon in one of the previous steps. As a result, the circuit forming region 101a and the non-circuit forming region 101b are electrically insulated from each other. Thus, next, in the seventh step (FIG. G), electric current is passed into the surface of the electroless plating 105 on the circuit forming region 101a of the substrate 101 surface, to electroplate the surface to form an electroplating 106. For the electroplating 106, a known means may be used. In the case of, for example, copper-electroplating, the composition of a bath therefor is made, for example, as follows: CuSO₄·5H₂O (75 g)/l H₂SO₄(190 g)/l Cl (60 ppm) /additives (appropriate amount). The material of the anode is phosphorus-containing copper, the temperature of the bath is set to 25°C, and the current density of the cathode is set to 2.5 A/dm².

Finally, in the eighth step (FIG. H), the electroless plating 105 on the non-circuit forming region 101b of the substrate 101 surface is removed by etching. Detailedly, the electroplating 106 in one of the previous steps can easily be made thicker than the electroless plating 105; therefore, when the plating thickness of the electroplating 106 has been made sufficiently larger than that of the electroless plating 105, only the electroless plating 105, which is thinner, can be removed by etching. For the etching, for example, the substrate 101 is immersed in an aqueous solution of sodium persulfate for 1 minute.

The next figures, FIG. 3 illustrates still another method according to the invention for producing a formed circuit component. This production method has first to fifth steps (FIGS. A to E). The first to third steps (FIGS. A to C) are equivalent to the first to third steps illustrated in FIG. 1. In the fourth step (FIG. D), the entire surface of the substrate 201 is electroless-plated to form an electroless plating 205. A means for the electroless plating 205 is equivalent to the means described with reference to FIG. 1.

In the fifth step (FIG. E), a second laser ray 204 is radiated selectively onto the non-circuit forming region 201b, to remove the electroless plating 205 formed on this non-circuit forming region. The specification and the effect of the second laser ray 204 are equivalent to those described with reference to FIG. 1. The second laser ray 204 is radiated to make an invasion into the circuit forming region 201a, in such a manner that the first-laser-ray-radiated area and the second-laser-ray-radiated area overlap with each other. Onto the electroless plating 205 formed on the circuit forming region 201a, electroplating can easily be attained to deposit an electroplating 205 thereon.

The next figures, FIG. 4 illustrates a further method according to the invention for producing a formed circuit component. This production method has first to seventh steps (FIGS. A to G). The first to fourth steps (FIGS. A to D) are equivalent to the first to fourth steps illustrated in FIG. 3. In the fifth step (FIG. E), a second laser ray 304 is radiated onto a boundary 301c between the circuit forming region 301a and the non-circuit forming region 301b of the substrate 301 surface, to remove the electroless plating 305 formed on this boundary. The specification and the effect of the second laser ray 304 are equivalent to those described with reference to FIG. 1. The second laser ray 304 is radiated to make an invasion into the circuit forming region 301a, in such a manner that the first-laser-ray-radiated area and the second-laser-ray-radiated area overlap with each other.

Next, in the sixth step (FIG. F), electric current is passed into the electroless plating 305 on the circuit forming region 301a, and being electrically insulated from the non-circuit forming region 301b, to deposit an electroplating 306 onto the electroless plating 305. A means for the electroplating 306 is equivalent to those described with reference to FIG. 2. The electroplating 306 is formed to have a sufficiently larger thickness than that of the electroless plating 305. Finally, in the eighth step (FIG. H), the electroless plating 305 on the non-circuit forming region 301b is removed by etching. A means for the etching is equivalent to that described with reference to FIG. 2.

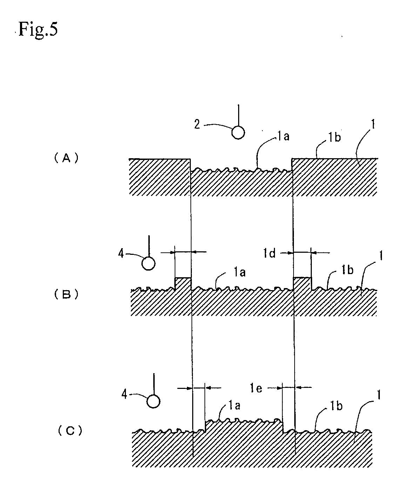

Lastly, with reference to FIG. 5, a description is again made about the significance of the technique that when only the circuit forming region 1a or analogue of the substrate-1- or analogue-surface is selectively roughened by the radiation of the first laser ray 2 or analogue, the second laser ray 4 or analogue in one of the subsequent steps is radiated onto this circuit forming region, so as to give the overlap. Detailedly, as illustrated in FIG. 5 (A), when only the circuit forming region 1a of the substrate 1 surface is selectively roughened by the first laser ray 2 and in one of the subsequent steps the second laser ray 4 is radiated thereto, it is very difficult to radiate the second laser ray 4 precisely along the circumferential edge of the circuit forming region 1a that has been roughened by the radiation of the first laser ray.

As illustrated in FIG. 5 (B), therefore, there is a large possibility that the scope onto which the second laser ray 4 is radiated removes, by imprecision, from the circuit forming region 1a made rough by the first laser ray 2 toward the outside thereof, so that a region 1d which is not irradiated with the second laser ray 4 remains between the circumferential edge of the circuit forming region 1a roughened and the scope irradiated with the second laser ray 4. In this case, the catalyst function in the region 1d which is not irradiated therewith is not eliminated. Consequently an electroless plating 5 precipitates and remains on this region 1d. When an electroless plating 5 is present in the region 1d, there are caused problems including a problem that it is difficult to form a precise electroconductive circuit.

As illustrated in FIG. 5(C), therefore, when the second laser ray 4 is radiated, it is advisable to radiate the ray onto an area extending from the circumferential edge of the circuit forming region 1a made rough, to make an invasion by a predetermined width 1e, into the inside thereof, in such a manner that the first-laser-ray-radiated area and the second-layer-ray-radiated area overlap with each other. In this case, it is possible to prevent, with ease and certainty, the generation of a region which is not made rough by the first laser ray and not irradiated with the second laser ray. Accordingly, when a region obtained by excluding the area of overlap 1e from a circumferential of the circuit forming region 1a made rough, is beforehand set as a real circuit forming region, the electroconductive circuit can be formed with precision and ease on the real circuit forming region.

About the adhesive strength between the electroless plating 5 or analogue and the substrate 1 or analogue made rough by the radiation of the first laser ray 2, a peeling strength test was made. As a result, the peeling strength was from 1.5 to 2.0 kg/cm. Thus, it was verified that the adhesive strength based on the present invention where the laser ray irradiation is used for roughening was equivalent to that based on the prior art where the chemical etching is used for roughening.

### Industrial Applicability

The invention makes it possible to roughen the surface of a substrate without using any chemical etchant to keep a sufficient adhesive strength certainly between the surface and an electroless plating thereon. Accordingly, the invention can widely be used in industries concerned with electronic instruments and others.

## Claims

1. A method for producing a formed circuit component, comprising:
a first step of forming a substrate composed of an insulating material;
a second step of radiating a first laser ray thereon, thereby roughening only a circuit forming region of a substrate surface;
a third step of immersing the substrate in a catalytic liquid, thereby supplying a catalyst for electroless-plating onto the substrate surface;
a fourth step of drying the substrate surface, thereby fixing the catalyst onto the substrate surface;
a fifth step of radiating a second laser ray onto a non-circuit forming region of the substrate surface, thereby lowering or eliminating the function of the catalyst fixed onto the non-circuit forming region; and
a sixth step of electroless-plating the circuit forming region of the substrate surface,
wherein in the fifth step, the second laser ray is radiated onto an area extending from the circumferential edge of the circuit forming region toward the inside of the circuit forming region in such a manner that the second-layer-ray-radiated area overlaps with the first-laser-ray-radiated area by only a predetermined width,
whereby around the circumferential edge of the circuit forming region roughened by the radiation of the first laser ray, the generation of a region that is not irradiated with the first laser ray so as not to be roughened, and is not irradiated with the second laser ray is prevented.

2. A method for producing a formed circuit component, comprising:
a first step of forming a substrate composed of an insulating material;
a second step of radiating a first laser ray thereon, thereby roughening only a circuit forming region of a substrate surface;
a third step of immersing the substrate in a catalytic liquid, thereby supplying a catalyst for electroless-plating onto the substrate surface;
a fourth step of drying the substrate surface, thereby fixing the catalyst onto the substrate surface;
a fifth step of radiating a second laser ray onto a boundary between the circuit forming region and a non-circuit forming region of the substrate surface, thereby lowering or eliminating the function of the catalyst fixed onto the boundary;
a sixth step of electroless-plating the circuit forming region and the non-circuit forming region of the substrate surface;
a seventh step of electroplating a surface of the electroless plating on the circuit forming region of the substrate surface; and
an eighth step of removing the electroless plating on the non-circuit forming region of the substrate surface by etching
wherein in the fifth step, the second laser ray is radiated onto an area extending from the circumferential edge of the circuit forming region toward the inside of the circuit forming region in such a manner that the second-layer-ray-radiated area overlaps with the first-laser-ray-radiated area by only a predetermined width,
whereby around the circumferential edge of the circuit forming region roughened by the radiation of the first laser ray, the generation of a region that is not irradiated with the first laser ray so as not to be roughened, and is not irradiated with the second laser ray is prevented.

3. A method for producing a formed circuit component, comprising:
a first step of forming a substrate composed of an insulating material;
a second step of radiating a first laser ray thereon, thereby roughening only a circuit forming region of a substrate surface;
a third step of immersing the substrate in a catalytic liquid, thereby supplying a catalyst for electroless-plating onto the substrate surface;
a fourth step of electroless-plating the substrate surface; and
a fifth step of radiating a second laser ray onto a non-circuit forming region of the substrate surface, thereby removing the electroless plating on the non-circuit forming region,
wherein in the fifth step, the second laser ray is radiated onto an area extending from the circumferential edge of the circuit forming region toward the inside of the circuit forming region in such a manner that the second-layer-ray-radiated area overlaps with the first-laser-ray-radiated area by only a predetermined width.

4. A method for producing a formed circuit component, comprising:
a first step of forming a substrate composed of an insulating material;
a second step of radiating a first laser ray thereon, thereby roughening only a circuit forming region of a substrate surface;
a third step of immersing the substrate in a catalytic liquid, thereby supplying a catalyst for electroless-plating onto the substrate surface;
a fourth step of electroless-plating the substrate surface;
a fifth step of radiating a second laser ray onto a boundary between the circuit forming region and a non-circuit forming region of the substrate surface, thereby removing the electroless plating applied to the boundary;
a sixth step of electroplating a surface of the electroless plating on the circuit forming region of the substrate; and
a seventh step of removing the electroless plating on the non-circuit forming region of the substrate surface by etching,
wherein in the fifth step, the second laser ray is radiated onto an area extending from the circumferential edge of the circuit forming region toward the inside of the circuit forming region in such a manner that the second-layer-ray-radiated area overlaps wit the first-laser-ray-radiated area by only a predetermined width.

## Patentansprüche

1. Verfahren zum Herstellen einer geformten Schaltungskomponente, das umfasst:
einen ersten Schritt des Formens eines Substrats, das aus einem Isoliermaterial gebildet ist;
einen zweiten Schritt des Strahlens eines ersten Laserstrahls darauf, um dadurch nur einen Schaltungsformungsbereich einer Substratoberfläche aufzurauen;
einen dritten Schritt des Eintauchens des Substrats in eine katalytische Flüssigkeit, um dadurch einen Katalysator für chemisches Beschichten auf der Substratoberfläche bereitzustellen;
einen vierten Schritt des Trocknens der Substratoberfläche, um dadurch den Katalysator auf der Substratoberfläche zu fixieren;
einen fünften Schritt des Strahlens eines zweiten Laserstrahls auf einen Nichtschaltungsformungsbereich der Substratoberfläche, um dadurch die Funktion des auf dem Nichtschaltungsformungsbereich fixierten Katalysators zu verringern oder zu beseitigen; und
einen sechsten Schritt des chemischen Beschichtens des Schaltungsformungsbereichs der Substratoberfläche,
wobei in dem fünften Schritt der zweite Laserstrahl auf einen Bereich gestrahlt wird, der sich von der Umfangskante des Schaltungsformungsbereichs zu der Innenseite des Schaltungsformungsbereichs erstreckt, derart, dass der mit dem zweiten Laserstrahl bestrahlte Bereich mit dem mit dem ersten Laserstrahl bestrahlten Bereich nur auf einer vorgegebenen Breite überlappt,
wodurch um die Umfangskante des Schaltungsformungsbereichs, der durch die Strahlung des ersten Laserstrahls aufgeraut worden ist, die Erzeugung eines Bereichs, der nicht mit dem ersten Laserstrahl bestrahlt wird, um nicht aufgeraut zu werden, und nicht mit dem zweiten Laserstrahl bestrahlt wird, verhindert wird.

2. Verfahren zum Herstellen einer geformten Schaltungskomponente, das umfasst:
einen ersten Schritt des Bildens eines Substrats, das aus einem Isoliermaterial gebildet ist;
einen zweiten Schritt des Strahlens eines ersten Laserstrahls darauf, um dadurch nur einen Schaltungsformungsbereich einer Substratoberfläche aufzurauen;
einen dritten Schritt des Eintauchens des Substrats in eine katalytische Flüssigkeit, um dadurch einen Katalysator zum chemischen Beschichten auf der Substratoberfläche bereitzustellen;
einen vierten Schritt des Trocknens der Substratoberfläche, um dadurch den Katalysator auf der Substratoberfläche zu fixieren;
einen fünften Schritt des Strahlens eines zweiten Laserstrahls auf eine Grenze zwischen dem Schaltungsformungsbereich und einem Nichtschaltungsformungsbereich der Substratoberfläche, um dadurch die Funktion des auf der Grenze fixierten Katalysators zu verringern oder zu beseitigen;
einen sechsten Schritt des chemischen Beschichtens des Schaltungsformungsbereichs und des Nichtschaltungsformungsbereichs der Substratoberfläche;
einen siebten Schritt des galvanischen Beschichtens einer Oberfläche der chemischen Beschichtung auf dem Schaltungsformungsbereich der Substratoberfläche; und
einen achten Schritt des Entfernens der chemischen Beschichtung auf dem Nichtschaltungsformungsbereich der Substratoberfläche durch Ätzen,
wobei in dem fünften Schritt der zweite Laserstrahl auf einen Bereich gestrahlt wird, der sich von der Umfangskante des Schaltungsformungsbereichs zu der Innenseite des Schaltungsformungsbereichs erstreckt, derart, dass der mit dem zweiten Laserstrahl bestrahlte Bereich mit dem mit dem ersten Laserstrahl bestrahlten Bereich nur auf einer vorgegebenen Breite überlappt,
wodurch um die Umfangskante des Schaltungsformungsbereichs, der durch die Strahlung des ersten Laserstrahls aufgeraut worden ist, die Erzeugung eines Bereichs, der nicht mit dem ersten Laserstrahl bestrahlt wird, um nicht aufgeraut zu werden, und nicht mit dem zweiten Laserstrahl bestrahlt wird, verhindert wird.

3. Verfahren zum Herstellen einer geformten Schaltungskomponente, das umfasst:
einen ersten Schritt des Bildens eines Substrats, das aus einem Isoliermaterial gebildet ist;
einen zweiten Schritt des Strahlens eines ersten Laserstrahls darauf, um dadurch nur einen Schaltungsformungsbereich einer Substratoberfläche aufzurauen;
einen dritten Schritt des Eintauchens des Substrats in eine katalytische Flüssigkeit, um dadurch einen Katalysator für chemisches Beschichten auf der Substratoberfläche bereitzustellen;
einen vierten Schritt des chemischen Beschichtens der Substratoberfläche; und
einen fünften Schritt des Strahlens eines zweiten Laserstrahls auf einen Nichtschaltungsformungsbereich der Substratoberfläche, um dadurch die chemische Beschichtung des Nichtschaltungsformungsbereichs zu entfernen,
wobei in dem fünften Schritt der zweite Laserstrahl auf einen Bereich gestrahlt wird, der sich von der Umfangskante des Schaltungsformungsbereichs zu der Innenseite des Schaltungsformungsbereichs erstreckt, derart, dass der mit dem zweiten Laserstrahl bestrahlte Bereich mit dem mit dem ersten Laserstrahl bestrahlten Bereich nur auf einer vorgegebenen Breite überlappt.

4. Verfahren zum Herstellen einer geformten Schaltungskomponente, das umfasst:
einen ersten Schritt des Bildens eines Substrats, das aus einem Isoliermaterial gebildet ist;
einen zweiten Schritt des Strahlens eines ersten Laserstrahls darauf, um dadurch nur einen Schaltungsformungsbereich einer Substratoberfläche aufzurauen;
einen dritten Schritt des Eintauchens des Substrats in eine katalytische Flüssigkeit, um dadurch einen Katalysator für chemisches Beschichten auf der Substratoberfläche bereitzustellen;
einen vierten Schritt des chemischen Beschichtens der Substratoberfläche;
einen fünften Schritt des Strahlens eines zweiten Laserstrahls auf eine Grenze zwischen dem Schaltungsformungsbereich und einem Nichtschaltungsformungsbereich der Substratoberfläche, um dadurch die auf die Grenze aufgebrachte chemische Beschichtung zu entfernen;
einen sechsten Schritt des galvanischen Beschichtens einer Oberfläche der chemischen Beschichtung auf dem Schaltungsformungsbereich des Substrats; und
einen siebten Schritt des Entfernens der chemischen Beschichtung auf dem Nichtschaltungsformungsbereich des Substrats durch Ätzen,
wobei in dem fünften Schritt der zweite Laserstrahl auf einen Bereich, der sich von der Umfangskante des Schaltungsformungsbereichs zu der Innenseite des Schaltungsformungsbereichs erstreckt, gestrahlt wird, derart, dass der mit dem zweiten Laserstrahl bestrahlte Bereich mit dem mit dem ersten Laserstrahl bestrahlten Bereich nur auf einer vorgegebenen Breite überlappt.

## Revendications

1. Méthode de fabrication d'un composant de circuit imprimé, comprenant :
une première étape de formation d'un substrat composé d'un matériau isolant ;
une deuxième étape d'irradiation du substrat par un premier rayon laser afin de rendre rugueuse uniquement une région de la surface du substrat formant le circuit ;
une troisième étape d'immersion du substrat dans un liquide catalytique afin de déposer sur la surface du substrat un catalyseur en vue d'un dépôt auto-catalytique ;
une quatrième étape de séchage de la surface du substrat pour fixer le catalyseur sur la surface du substrat ;
une cinquième étape d'irradiation d'une région de la surface du substrat ne formant pas le circuit avec un deuxième rayon laser afin de diminuer ou d'éliminer la fonction du catalyseur fixé sur la région ne formant pas le circuit ; et
une sixième étape de dépôt auto-catalytique sur la région de la surface du substrat formant le circuit,
où, lors de la cinquième étape, le deuxième rayon laser est projeté sur une superficie s'étendant du bord circonférentiel de la région formant le circuit vers l'intérieur de la région formant le circuit de telle manière que la superficie irradiée par le deuxième rayon laser chevauche la superficie irradiée par le premier rayon laser seulement d'une largeur prédéterminée,
où la formation d'une région non irradiée par le premier rayon laser pour ne pas la rendre rugueuse et non irradiée par le deuxième rayon laser autour du bord circonférentiel de la région formant le circuit rendue rugueuse par la radiation du premier rayon laser est empêchée.

2. Méthode de fabrication d'un composant de circuit imprimé, comprenant :
une première étape de formation d'un substrat composé d'un matériau isolant ;
une deuxième étape d'irradiation du substrat par un premier rayon laser afin de rendre rugueuse uniquement une région de la surface du substrat formant le circuit ;
une troisième étape d'immersion du substrat dans un liquide catalytique afin de déposer sur la surface du substrat un catalyseur en vue d'un dépôt auto-catalytique ;
une quatrième étape de séchage de la surface du substrat pour fixer le catalyseur sur la surface du substrat ;
une cinquième étape d'irradiation d'une frontière entre une région de la surface du substrat formant le circuit et une région de la surface du substrat ne formant pas le circuit avec un deuxième rayon laser afin de diminuer ou d'éliminer la fonction du catalyseur fixé sur la frontière ;
une sixième étape de dépôt auto-catalytique sur la région de la surface du substrat formant le circuit et sur la région de la surface du substrat ne formant pas le circuit ;
une septième étape d'électrodéposition sur une surface du dépôt auto-catalytique sur la région de la surface du substrat formant le circuit ; et
une huitième étape d'élimination par gravure du dépôt auto-catalytique sur la région de la surface du substrat ne formant pas le circuit,
où, lors de la cinquième étape, le deuxième rayon laser est projeté sur une superficie s'étendant du bord circonférentiel de la région formant le circuit vers l'intérieur de la région formant le circuit de telle manière que la superficie irradiée par le deuxième rayon laser chevauche la superficie irradiée par le premier rayon laser seulement d'une largeur prédéterminée,
où la formation d'une région non irradiée par le premier rayon laser pour ne pas la rendre rugueuse et non irradiée par le deuxième rayon laser autour du bord circonférentiel de la région formant le circuit rendue rugueuse par la radiation du premier rayon laser est empêchée.

3. Méthode de fabrication d'un composant de circuit imprimé, comprenant
une première étape de formation d'un substrat composé d'un matériau isolant ;
une deuxième étape d'irradiation du substrat par un premier rayon laser afin de rendre rugueuse uniquement une région de la surface du substrat formant le circuit ;
une troisième étape d'immersion du substrat dans un liquide catalytique afin de déposer sur la surface du substrat un catalyseur en vue d'un dépôt auto-catalytique ;
une quatrième étape de dépôt auto-catalytique sur la surface du substrat ; et
une cinquième étape d'irradiation d'une région de la surface du substrat ne formant pas le circuit avec un deuxième rayon laser afin d'éliminer le dépôt auto-catalytique de la région ne formant pas le circuit,
où, lors de la cinquième étape, le deuxième rayon laser est projeté sur une superficie s'étendant du bord circonférentiel de la région formant le circuit vers l'intérieur de la région formant le circuit de telle manière que la superficie irradiée par le deuxième rayon laser chevauche la superficie irradiée par le premier rayon laser seulement d'une largeur prédéterminée.

4. Méthode de fabrication d'un composant de circuit imprimé, comprenant :
une première étape de formation d'un substrat composé d'un matériau isolant ;
une deuxième étape d'irradiation du substrat par un premier rayon laser afin de rendre rugueuse uniquement une région de la surface du substrat formant le circuit ;
une troisième étape d'immersion du substrat dans un liquide catalytique afin de déposer sur la surface du substrat un catalyseur en vue d'un dépôt auto-catalytique ;
une quatrième étape de dépôt auto-catalytique sur la surface du substrat ;
une cinquième étape d'irradiation d'une frontière entre une région de la surface du substrat formant le circuit et une région de la surface du substrat ne formant pas le circuit avec un deuxième rayon laser afin d'éliminer la fonction du catalyseur fixé sur la frontière ;
une sixième étape d'électrodéposition sur une surface du dépôt auto-catalytique sur la région de la surface du substrat formant le circuit ; et
une septième étape d'élimination par gravure du dépôt auto-catalytique sur la région de la surface du substrat ne formant pas le circuit,
où, lors de la cinquième étape, le deuxième rayon laser est projeté sur une superficie s'étendant du bord circonférentiel de la région formant le circuit vers l'intérieur de la région formant le circuit de telle manière que la superficie irradiée par le deuxième rayon laser chevauche la superficie irradiée par le premier rayon laser seulement d'une largeur prédéterminée.
